# EUROPEAN PATENT APPLICATION

(11) **EP 4 703 620 A1**
(43) Date of publication of application: **04.03.2026**
(21) Application number: 25198614.7
(22) Date of filing: 28.08.2025
(51) Int. Cl.: F16M 11/04, F16M 13/00, G06F 1/16, F16M 11/00, F16M 11/18, G09F 9/00, G09F 9/30, F16M 11/24, G07G 1/12, F16M 11/10, F16M 11/06

(54) **DUAL-SCREEN STAND AND ELECTRONIC DEVICE**

(30) Priority: 30.08.2024 CN 202422130564 U; 30.08.2024 CN 202422130565 U; 09.01.2025 CN 202520045803 U; 09.01.2025 CN 202520045870 U
(71) Applicant: Fujian Landi Commercial Equipment Co., Ltd, Fuzhou, Fujian 350000 (CN)
(72) Inventor: ZHENG, Yunbin, Fuzhou, Fujian (CN); HU, Changfa, Fuzhou, Fujian (CN); ZHANG, Xiaoquan, Fuzhou, Fujian (CN); LIU, Jie, Fuzhou, Fujian (CN)
(74) Representative: Dall'Olio, Christian

(57) **Abstract**

The invention relates to a dual-screen stand and an electronic device. The dual-screen stand comprises a stand body, wherein the stand body is of a triangular prism-like structure, and one of edges of the stand body serves as a top. The stand body includes a first mounting surface and a second mounting surface which are connected to the top, the first mounting surface is configured for arranging a detachable first display module, and the second mounting surface is configured for arranging a detachable second display module.

## Description

### Technical Field

The invention relates to the technical field of stand applications, in particular to a dual-screen stand and an electronic device.

### Background Art

In related technologies, display screens are applied in various workplaces and living places.

In certain scenarios, business personnel need to conduct face-to-face business with clients, and a dual-display setup is usually adopted for mutual information confirmation and interaction between both parties. However, the existing dual-screen display stands have complex structures, are difficult to assemble, and are relatively large in size.

### Summary of the Invention

To solve the above technical problems, the technical solution adopted in the invention is as follows.

A dual-screen stand includes a stand body, where the stand body is of a triangular prism-like structure, and one of edges of the stand body serves as a top. The stand body includes a first mounting surface and a second mounting surface which are connected to the top, the first mounting surface is configured for arranging a detachable first display module, and the second mounting surface is configured for arranging a detachable second display module.

To solve the above technical problems, the technical solution adopted in the invention is as follows.

An electronic device includes the above dual-screen stand.

### Brief Description of the Drawings

FIG. 1 is a schematic diagram of a stand body according to one or more embodiments;
FIG. 2 is a schematic diagram of a dual-screen stand according to one or more embodiments;
FIG. 3 is a schematic diagram of a supporting platform according to one or more embodiments;
FIG. 4 is a schematic diagram of an internal module according to one or more embodiments;
FIG. 5 is a schematic diagram of a second mounting surface according to one or more embodiments;
FIG. 6 is a schematic diagram of a first slot according to one or more embodiments;
FIG. 7 is a schematic diagram of a first rotating shaft connector according to one or more embodiments;
FIG. 8 is a schematic diagram of a shielding component according to one or more embodiments;
FIG. 9 is a schematic diagram of a top according to one or more embodiments;
FIG. 10 is a schematic diagram illustrating assembly of a first rotating shaft connector according to one or more embodiments;
FIG. 11 is an enlarged view of a structure marked as a part A in FIG. 4;
FIG. 12 is an enlarged view of a structure marked as a part B in FIG. 7;
FIG. 13 is a schematic diagram of a fastening portion according to one or more embodiments;
FIG. 14 is a schematic diagram illustrating assembly of a second rotating shaft connector according to one or more embodiments;
FIG. 15 is an enlarged view of a structure marked as a part C in FIG. 14;
FIG. 16 is a schematic diagram illustrating assembly of a hanger according to one or more embodiments;
FIG. 17 is a schematic diagram of a hanger according to one or more embodiments;
FIG. 18 is a schematic diagram of a cavity portion according to one or more embodiments;
FIG. 19 is an enlarged view of the structure marked as the part A in FIG. 17;
FIG. 20 is a schematic diagram of a connection end face of a main body according to one or more embodiments;
FIG. 21 is a schematic diagram of an inner wall of a main body according to one or more embodiments;
FIG. 22 is a schematic diagram of a first display module according to one or more embodiments; and
FIG. 23 is an enlarged view of the structure marked as the part B in FIG. 22.

Reference numerals:
1. stand body; 101. top; 102. supporting platform; 1021. transition slot; 1022. wiring window; 1023. third slot; 103. internal module; 104. circuit mainboard; 105. connecting wire; 106. hollow portion; 107. threaded hole; 108. insertion slot; 1011. fastening portion; 109. hanging platform; 110. outer hanging surface;
11. first mounting surface; 111. first slot; 1111. first snap-fit member; 1112. second snap-fit matching member; 1113. sliding channel; 112. first notch; 12. second mounting surface; 121. wiring slot; 122. second notch; 123. second slot; 13. third mounting surface;
2. first rotating shaft connector; 21. first snap-fit matching member; 22. second snap-fit member; 201. first-level connecting block; 2011. wiring hole; 202. second-level connecting block; 203. third-level connecting block; 204. sliding block;
3. shielding component; 31. baffle; 311. first limiting groove; 32. rotating shaft; 33. cover; 331. insertion block; 332. first fixing hole; 333. reinforcing rib; 34. torsion spring;
341. abutting end;
4. second rotating shaft connector;
5. first display module; 521. connecting body; 5211. connecting groove; 5212. third limiting groove; 5213. interface groove; 522. second data interface; 523. screen body;
6. second display module;
7. hanger; 71. main body; 7011. vertical portion; 7012. cavity portion; 7013. rear cover;
7014. isolation edge; 711. first positioning component; 7111. connecting boss; 7112. limiting block; 712. second positioning component; 7121. interface cavity; 7122. circuit cavity; 7123. sub-cavity; 7124. positioning hole; 713. first data interface; 7131. second fixing hole; 714. data cable; 715. interface boss; 72. hanging member; 721. connecting hole.

### Detailed description of the embodiments

To make the technical problems, technical solutions, and beneficial effects to be solved by the invention clearer, the invention will be further described in detail below with reference to the accompanying drawings and embodiments. It should be understood that the specific embodiments described herein are merely used to explain the invention and are not intended to limit the invention.

In the following description, for the purpose of explanation rather than limitation, specific details such as specific system structures and technologies are set forth to provide a thorough understanding of the embodiments of the invention. However, it will be clear to those skilled in the art that the invention can also be implemented in other embodiments without these specific details. In other cases, detailed descriptions of well-known systems, devices, circuits, and methods are omitted to avoid unnecessary details from hindering the description of the invention.

It should be understood that when used in the specification of the invention and the appended claims, the term "comprising" indicates the presence of the described features, bodies, steps, operations, elements, and/or components, but does not exclude the presence or addition of one or more other features, bodies, steps, operations, elements, components, and/or combinations thereof.

In the specification of the invention, references to "one embodiment" or "some embodiments" and the like mean that a specific feature, structure, or characteristic described in connection with the embodiment is included in one or more embodiments of the invention. Therefore, phrases such as "in one embodiment," "in some embodiments," "in some other embodiments," and "in still some other embodiments" used in different places in this specification do not necessarily refer to the same embodiments, but rather mean "one or more embodiments, but not all embodiments," unless specifically emphasized otherwise. The terms "including," "comprising," "having" and their variations all mean "including, but not limited to", unless specifically emphasized otherwise.

In related technologies, business personnel need to conduct face-to-face business with clients, and a dual-display setup is usually adopted for mutual information confirmation and interaction between both parties. However, the dual-screen display stands in the related technologies have complex structures, are difficult to assemble, and are relatively large in size.

To solve the above technical problems, the invention provides a dual-screen stand, which includes a stand body 1, and the stand body 1 is of a triangular prism-like structure;
one of edges of the stand body 1 serves as a top 101;
the stand body 1 includes a first mounting surface 11 and a second mounting surface 12 which are connected to the top 101;
the first mounting surface 11 is configured for arranging a detachable first display module 5; and
the second mounting surface 12 is configured for arranging a detachable second display module 6.

As can be seen from the above description, the beneficial effects of the invention lie in that the stand body with the triangular prism-like structure is adopted, and the edge of the top serves as a supporting core to form a compact spatial layout, thereby reducing the overall size. The first mounting surface and the second mounting surface are respectively arranged on both sides of the edge of the top, enabling the two display modules to be symmetrically arranged to meet the needs of face-to-face interaction. Both the first mounting surface and the second mounting surface adopt a design of the detachable display module, reducing the installation complexity through modular assembly, while also facilitating later maintenance or replacement.

In some embodiments of the invention, a supporting platform 102 is arranged on the edge of the top 101, and the supporting platform 102 is configured to place an internal module 103.

As can be seen from the above description, by arranging the supporting platform for placing the internal module on the edge of the top, the space utilization of the stand body is improved.

In some embodiments of the invention, a first slot 111 is formed in the first mounting surface 11; and
the first slot 111 is configured for arranging the detachable first display module 5.

As can be seen from the above description, by forming the first slot in the first mounting surface, the display module can be quickly installed or disassembled through an insertion method.

In some embodiments of the invention, the dual-screen stand further includes a first rotating shaft connector 2;
one end of the first rotating shaft connector 2 is inserted into the first slot 111;
the other end of the first rotating shaft connector 2 is configured to be connected to the first display module 5.

As can be seen from the above description, the first display module can be rotatably connected by using the first rotating shaft connector, allowing for the adjustment of the display angle of the first display module, thereby improving the practicability of the first display module.

In some embodiments of the invention, a shielding component 3 is arranged at the entrance of the first slot 111; and
the shielding component 3 includes a baffle 31, and the baffle 31 is movably arranged at the entrance of the first slot 111.

As can be seen from the above description, by arranging the rotatable baffle at the entrance of the slot, the baffle rotates to avoid obstruction when the rotating shaft connector is inserted into the first slot, and the baffle of the shielding component resets and covers the entrance of the slot when the rotating shaft connector is pulled out, achieving a dust-proof effect. This facilitates the insertion of the first rotating shaft connector while also protecting the interface.

In some embodiments of the invention, the shielding component 3 further includes a cover 33;
a fastening portion 1011 is arranged on the top 101;
the cover 33 is arranged on the fastening portion 1011; and
the baffle 31 is arranged on the cover 33 through a rotating shaft 32.

As can be seen from the above description, by composing the shielding component with the cover and the baffle, a detachable connection is formed between the shielding component and the stand body, facilitating the installation of the shielding component, and allowing for replacement of the shielding component when damaged, thereby improving the overall durability of the structure.

In some embodiments of the invention, a torsion spring 34 is arranged on one side of the cover 33;
the torsion spring 34 is sleeved on the rotating shaft 32;
one end of the torsion spring 34 abuts against the cover 33, and the other end of the torsion spring 34 abuts against the baffle 31.

As can be seen from the above description, by arranging the rotating shaft and the torsion spring structure, and making the torsion spring abut against the cover and the baffle respectively, the functions of automatic reset and forced flipping of the baffle are achieved.

In some embodiments of the invention, a first limiting groove 311 is formed in the baffle 31; and
an abutting end 341 of the torsion spring 34 is arranged in the first limiting groove 311. As can be seen from the above description, by forming the first limiting groove in the baffle and arranging the abutting end of the torsion spring in the first limiting groove, the torsion spring is fixed in place to prevent its movement, thereby making the force on the baffle more stable.

In some embodiments of the invention, an insertion block 331 is arranged at a first end of the cover 33; and
an insertion slot 108 connected to the insertion block 331 is formed in the stand body 1.

As can be seen from the above description, by arranging the insertion block on the cover and forming the insertion slot in the stand body, the cover and the stand body can be more easily connected through the cooperation between the insertion block and the insertion slot. This also improves the stability between the cover and the stand body. In some embodiments of the invention, a first fixing hole 332 is formed in one side of the cover 33 close to the stand body 1, and the first fixing hole 332 is configured to be connected to the stand body 1.

As can be seen from the above description, by forming the first fixing hole in the cover and fixedly connecting the cover with the stand body through the first fixing hole, the stability between the cover and the stand body is improved.

In some embodiments of the invention, first snap-fit members 1111 are arranged on inner walls of both sides of the first slot 111;
first snap-fit matching members 21 are arranged on both sides of the first rotating shaft connector 2 along the insertion direction; and
the first snap-fit members 1111 are snap-fitted with the first snap-fit matching members 21.

As can be seen from the above description, by arranging the first snap-fit members in the first slot and arranging the first snap-fit matching members on the first rotating shaft connector, a snap-fit engagement is formed between the first snap-fit members and the first snap-fit matching members, thereby improving the stability of the connection between the first display module and the stand body.

In some embodiments of the invention, second snap-fit matching members 1112 are arranged on the inner walls of both sides of the first slot 111;
second snap-fit members 22 are arranged on both sides of the first rotating shaft connector 2 along the insertion direction; and
the second snap-fit members 22 are snap-fitted with the second snap-fit matching members 1112.

As can be seen from the above description, on the basis of the snap-fit engagement formed between the first snap-fit members and the first snap-fit matching members, second snap-fit members are further arranged on the first rotating shaft connector, and second snap-fit matching members are arranged in the first slot. Through the engagement between the two groups of snap-fit members and snap-fit matching members, the stability of the connection between the first display module and the stand is improved.

In some embodiments of the invention, sliding blocks 204 are arranged on both sides of the first rotating shaft connector 2 along the insertion direction; and sliding channels 1113 adapted to the sliding blocks 204 are arranged on the inner walls of both sides of the first slot 111.

As can be seen from the above description, by arranging the sliding channels on both sides of the first slot and arranging the sliding blocks on both sides of the first rotating shaft connector, the first rotating shaft connector is guided during the insertion process through the cooperation between the sliding channels and the sliding blocks, facilitating the connection between the first rotating shaft connector and the first slot.

In some embodiments of the invention, the end of the first rotating shaft connector 2 inserted into the first slot 111 is stepped;
the first rotating shaft connector 2 includes a first-level connecting block 201, a second-level connecting block 202, and a third-level connecting block 203;
the second-level connecting block 202 has a greater length than the first-level connecting block 201;
the third-level connecting block 203 has a greater length and width than the first-level connecting block 201; and
the first slot 111 is stepped and adapted to the second-level connecting block 202 and the third-level connecting block 203.

As can be seen from the above description, by making one end of the first rotating shaft connector stepped, the first-level connecting block, the second-level connecting block, and the third-level connecting block facilitate the alignment and insertion of the first rotating shaft connector with the stand body, thereby improving the stability of the connection between the first display module and the stand body.

In some embodiments of the invention, a wiring hole 2011 communicating along the insertion direction is formed in the first-level connecting block 201.

As can be seen from the above description, by forming the wiring hole in the first-level connecting block, the first-level connecting block is used for wiring connection, thereby connecting a circuit on the stand body with the first display module through the wiring hole, and avoiding exposed wiring which could affect the attractiveness and operation. In some embodiments of the invention, a first notch 112 is formed in one end of the first mounting surface 11 close to the top 101;
a second notch 122 is formed in one end of the second mounting surface 12 close to the top 101; and
the first notch 112 communicates with the second notch 122, the fastening portion 1011 is formed at the top.

As can be seen from the above description, the first notch and the second notch limit the installation positions of the first display module and the second display module, and the first notch and the second notch are in communication to form the fastening portion, facilitating the assembly of the internal module on the supporting platform.

In one embodiment of the invention, a transition slot 1021 is formed in the supporting platform 102;
a hollow wiring window 1022 is arranged at one end of the transition slot 1021 close to the second mounting surface 12.

As can be seen from the above description, by forming the transition slot in the supporting platform and arranging a hollow wiring window in the transition slot, exposed wiring is avoided, thereby improving the attractiveness.

In some embodiments of the invention, the stand body 1 further includes a third mounting surface 13 parallel to the top 101;
a circuit mainboard 104 is arranged on the third mounting surface 13;
a wiring slot 121 is formed in one side of the second mounting surface 12 close to the first mounting surface 11; and
a connecting wire 105 for connecting the circuit mainboard 104 is arranged in the wiring slot 121.

As can be seen from the above description, by arranging the circuit mainboard on the third mounting surface, the internal space of the stand body is utilized, reducing the overall size of the stand. Meanwhile, by forming the wiring slot in the back side of the second mounting surface, exposed wiring is avoided, and wires are protected.

In some embodiments of the invention, the dual-screen stand further includes a hanger 7;
the hanger 7 includes a main body 71 and a hanging member 72;
the hanging member 72 is arranged at the top of the main body 71; and
a hanging platform 109 on the stand body 1 and an outer hanging surface 110 form an obtuse hanging angle, and a corresponding hanging angle is formed between the hanging member 72 and the main body 71.

As can be seen from the above description, by arranging the main body and the hanging member to form the hanger, the hanger and the stand body are connected in a hanging manner, allowing for flexible disassembly between the two, and meeting the needs of users in different scenarios.

To solve the above technical problems, the invention provides an electronic device, which includes the above dual-screen stand.

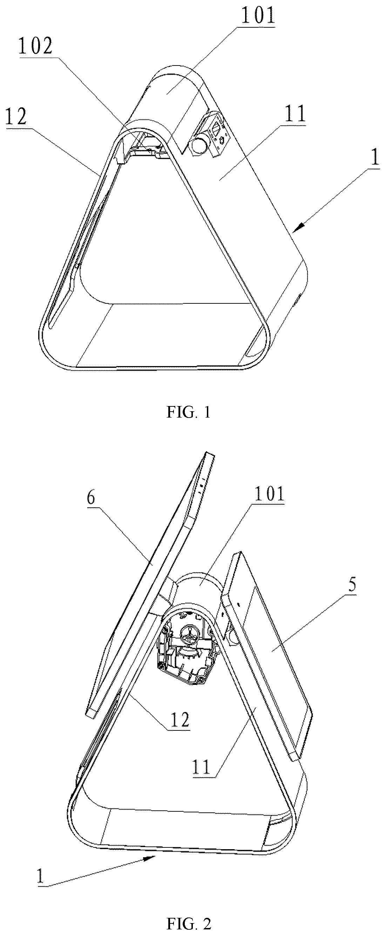

The dual-screen stand and the electronic device provided in the invention are applied to financial terminals such as cash registers, self-service terminals, and payment devices, which are illustrated below through specific implementations:
In one embodiment of the invention, as shown in FIG. 1, a dual-screen stand includes a stand body 1. The stand body 1 is of a triangular prism-like structure, and one of edges of the stand body 1 serves as a top 101. The stand body 1 includes a first mounting surface 11 and a second mounting surface 12 which are connected to the top 101. As shown in FIG. 2, the first mounting surface 11 is configured for arranging a detachable first display module 5. The second mounting surface 12 is configured for arranging a detachable second display module 6.

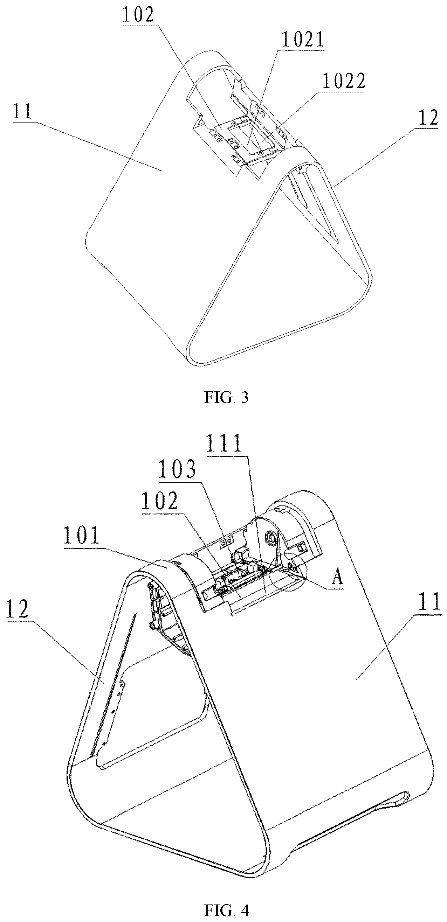

As shown in FIG. 1, a supporting platform 102 is arranged on the edge of the top 101, and the supporting platform 102 is configured to place an internal module 103. Both ends of the supporting platform 102 are respectively connected to the first mounting surface 11 and the second mounting surface 12 to form an A-shaped structure. The first mounting surface 11 and the second mounting surface 12 support each other to improve the stability of the stand structure. As shown in FIG. 3, a transition slot 1021 is formed in the supporting platform 102, and a hollow wiring window 1022 is arranged at one end of the transition slot 1021 close to the second mounting surface 12.

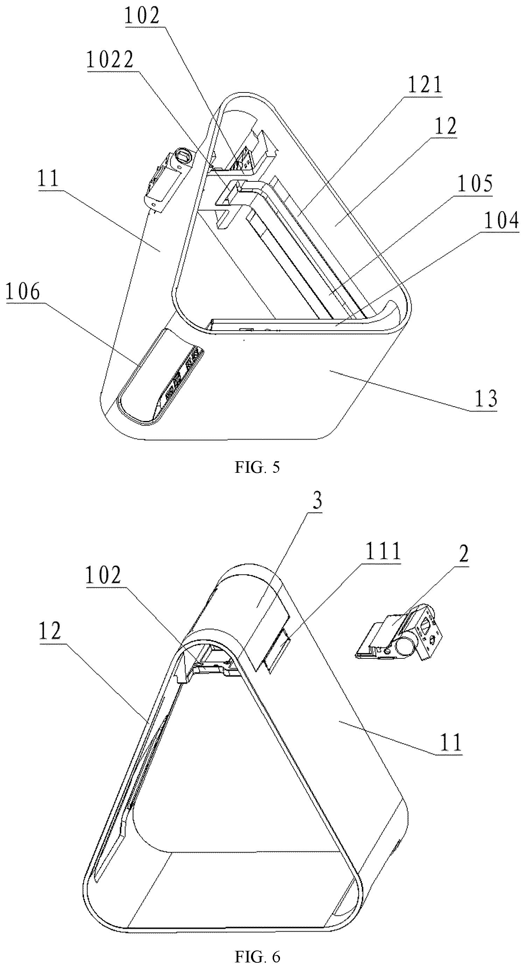

As shown in FIG. 4, the internal module 103 is assembled in an accommodating space formed among the first mounting surface 11, the second mounting surface 12, and the supporting platform 102. The internal module 103 includes a control module for controlling the first display module 5 and the second display module 6, and a speaker for playing audio. In the invention, by reasonably arranging the supporting platform 102, the extra space of the stand body 1 is effectively utilized, thereby improving the space utilization of the stand while reducing the occupied space of the dual-screen stand. As shown in FIG. 5, the stand body 1 further includes a third mounting surface 13 parallel to the top 101, a circuit mainboard 104 is arranged on the third mounting surface 13, a wiring slot 121 is formed in the side of the second mounting surface 12 close to the first mounting surface 11, and a connecting wire 105 for connecting the circuit mainboard 104 is arranged in the wiring slot 121. In one optional implementation, the control module for controlling the first display module 5 and the second display module 6 is arranged in the transition slot 1021 of the supporting platform 102, and the connecting wire 105 is routed through the wiring window 1022 and the wiring slot 121. The control module is electrically connected to the circuit mainboard 104 on the third mounting surface 13 through the connecting wire 105.

As shown in FIG. 5, the first mounting surface 11, the second mounting surface 12, and the third mounting surface 13 are connected end to end to form the triangular prism-like structure. In one optional implementation, arc connections are provided between the first mounting surface 11 and the second mounting surface 12, between the second mounting surface 12 and the third mounting surface 13, as well as between the first mounting surface 11 and the third mounting surface 13, providing an elastic deformation space between the first mounting surface 11 and the second mounting surface 12, thereby optimizing the overall stress structure of the stand, and further improving the stability while also enhancing the attractiveness of a product. In the invention, the first mounting surface 11, the second mounting surface 12, the third mounting surface 13, and the supporting platform 102 are of an integrally formed structure, and the third mounting surface 13 is parallel to the supporting platform 102. In addition, a hollow portion 106 is arranged at the connection between the second mounting surface 12 and the third mounting surface 13, and the hollow portion 106 is configured to route the interface wires of the circuit mainboard 104. By arranging the hollow portion 106 to route the interface wires that need to be connected to an external power source, the attractiveness of the product is ensured without the need to bend the interface wires, thereby improving its practicability.

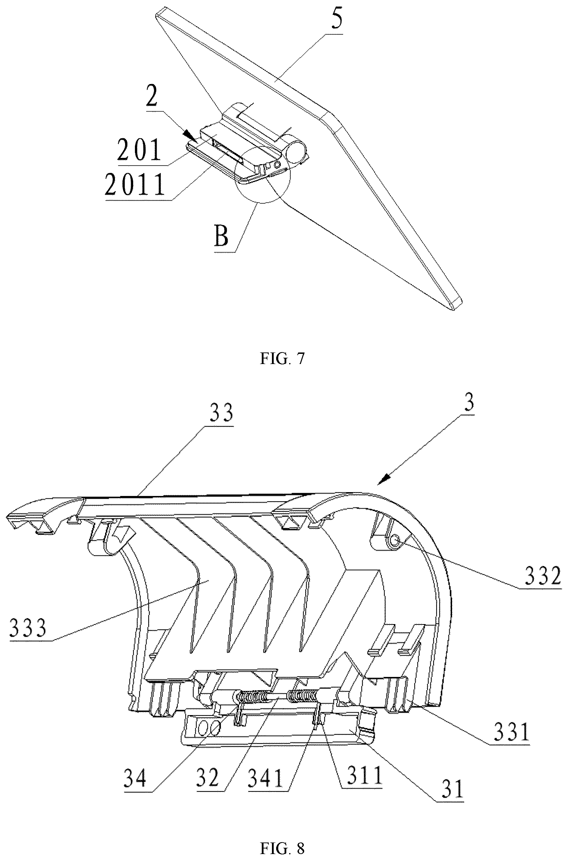

As shown in FIGs. 6 and 7, a first slot 111 is formed in the first mounting surface 11, and the first slot 111 is configured for arranging the detachable first display module 5. In one optional implementation, the first slot 111 extends from the first mounting surface 11 to the supporting platform 102, expanding the contact area between the first slot 111 and the first display module 5, thereby improving the stability of the installation of the first display module 5. The dual-screen stand further includes a first rotating shaft connector 2, one end of the first rotating shaft connector 2 is inserted into the first slot 111, and the other end of the first rotating shaft connector 2 is configured to be connected to the first display module 5. A shielding component 3 is arranged at the entrance of the first slot 111.

As shown in FIG. 8, the shielding component 3 includes a baffle 31, a rotating shaft 32, and a cover 33. The baffle 31 is arranged on the cover 33 through the rotating shaft 32, enabling the baffle 31 to be movably arranged at the entrance of the first slot 111. When the first rotating shaft connector 2 is inserted into the first slot 111, the baffle 31 flips upwards to expose the entrance of the first slot 111. When the first rotating shaft connector 2 is disconnected from the first slot 111, the baffle 31 resets downwards to cover the entrance of the first slot 111. In one optional implementation, a torsion spring 34 is arranged on one side of the cover 33, and the torsion spring 34 is sleeved on the rotating shaft 32. One end of the torsion spring 34 abuts against the cover 33, and the other end of the torsion spring 34 abuts against the baffle 31. A first limiting groove 311 is formed in the baffle 31, and the abutting end 341 of the torsion spring 34 is arranged in the first limiting groove 311.

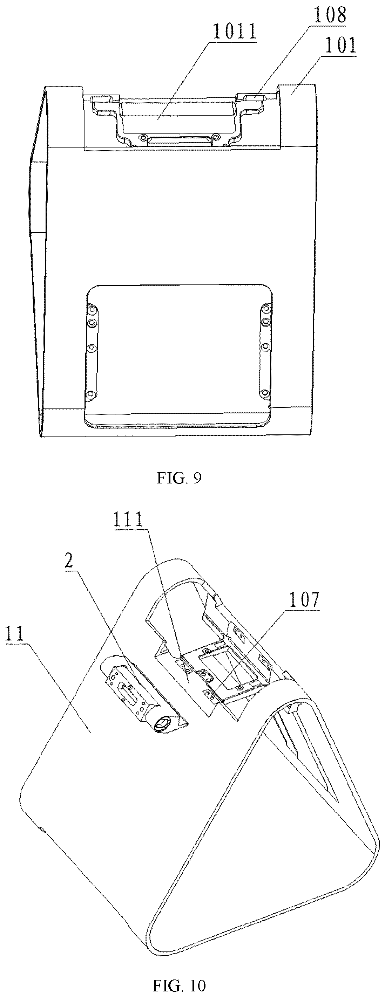

As shown in FIGs. 8 and 9, the top 101 is provided with a fastening portion 1011, and the cover 33 is arranged on the fastening portion 1011. In one optional implementation, the fastening portion 1011 is a triangular arc-shaped opening on the stand body 1. An insertion block 331 is arranged at a first end of the cover 33, and an insertion slot 108 connected to the insertion block 331 is formed in the stand body 1. To further improve the stability of the connection between the cover 33 and the stand body 1, a buckle and a first fixing hole 332 are arranged at the side of the cover 33 close to the stand body 1, the buckle is used for fastening with the stand body 1, and the first fixing hole 332 is configured to be connected to the stand body 1. Meanwhile, reinforcing ribs 333 are arranged on the inner side of the cover 33 to improve the strength of the cover 33.

In one embodiment of the invention, as shown in FIG. 10, a threaded hole 107 is formed in the first slot 111, and the first rotating shaft connector 2 is arranged on the first mounting surface 11 by fitting with the threaded hole 107 through a screw.

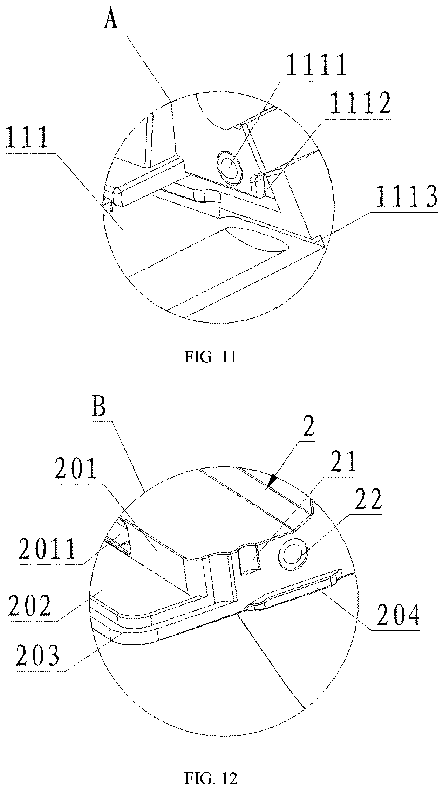

In one embodiment of the invention, as shown in FIGs. 11 and 12, the first rotating shaft connector 2 is connected to the first slot 111 in the first mounting surface 11 through sliding snap-fit limiting. The implementation of the sliding snap-fit limiting includes the following three modes.

In one optional implementation manner, first snap-fit members 1111 are arranged on the inner walls of both sides of the first slot 111; first snap-fit matching members 21 are arranged on both sides of the first rotating shaft connector 2 along the insertion direction; and the first snap-fit members 1111 are snap-fitted with the first snap-fit matching members 21.

In another optional implementation, second snap-fit matching members 1112 are arranged on the inner walls of both sides of the first slot 111; second snap-fit members 22 are arranged on both sides of the first rotating shaft connector 2 along the insertion direction; and the second snap-fit members 22 are snap-fitted with the second snap-fit matching members 1112.

In yet another optional implementation, first snap-fit members 1111 are arranged on the inner walls of both sides of the first slot 111, first snap-fit matching members 21 are arranged on both sides of the first rotating shaft connector 2 along the insertion direction, and the first snap-fit members 1111 are snap-fitted with the first snap-fit matching members 21. Meanwhile, second snap-fit matching members 1112 are arranged on the inner walls of both sides of the first slot 111, second snap-fit members 22 are arranged on both sides of the first rotating shaft connector 2 along the insertion direction, and the second snap-fit members 22 are snap-fitted with the second snap-fit matching members 1112.

In one optional implementation, the number of the first snap-fit members 1111, the second snap-fit members 22, the first snap-fit matching members 21, and the second snap-fit matching members 1112 is set according to actual situations. In other words, at least one group of first snap-fit members 1111 and/or second snap-fit matching members 1112 are arranged on the inner walls of both sides of the first slot 111, and at least one group of first snap-fit members 1111 and/or second snap-fit matching members 1112 are correspondingly arranged on the first rotating shaft connector 2, thereby forming snap-fitting engagement between the first rotating shaft connector 2 and the first slot 111.

In the invention, the first snap-fit members 1111 and the second snap-fit members 22 include marbles, and the first snap-fit matching members 21 and the second snap-fit matching members 1112 include second limiting grooves. As shown in FIGs. 11 and 12, a group of second limiting grooves and a group of marbles are arranged on the first rotating shaft connector 2, and a group of second limiting grooves and a group of marbles are also correspondingly arranged on the inner walls of both sides of the first slot 111. The snap-fit engagement with the second limiting grooves is achieved using the retractable marbles, facilitating the insertion and disassembly of the first rotating shaft connector 2 and the stand body 1.

As shown in FIGs. 11 and 12, sliding blocks 204 are arranged on both sides of the first rotating shaft connector 2 along the insertion direction; sliding channels 1113 adapted to the sliding blocks 204 are arranged on the inner walls of both sides of the first slot 111. In one optional implementation, the sliding blocks 204 are arranged on both sides of the third-level connecting block 203.

As shown in FIG. 12, the end of the first rotating shaft connector 2 inserted into the first slot 111 is stepped, the first rotating shaft connector 2 includes a first-level connecting block 201, a second-level connecting block 202, and a third-level connecting block 203, a length of the second-level connecting block 202 is greater than a length of the first-level connecting block 201, the third-level connecting block 203 has a greater length and width than the first-level connecting block 201, and the first slot 111 is stepped and adapted to the second-level connecting block 202 and the third-level connecting block 203. A wiring hole 2011 communicating along the insertion direction is formed in the first-level connecting block 201. The wiring hole 2011 is configured to connect the first display module 5 with the control module on the supporting platform 102.

The installation and disassembly process of the above first rotating shaft connector 2 and the first slot 111 is as follows.

During installation: through the cooperation between the third-level connecting block 203 and the sliding channel 1113, the first rotating shaft connector 2 is inserted into the first slot 111. At the same time, both the marbles on the first slot 111 and on the first rotating shaft connector 2 are compressed inward under pressure until the first rotating shaft connector 2 moves to the bottom of the first slot 111. When moving to the position of the first limiting groove 311, the marbles pop out and form snap-fit engagement with the first limiting groove 311. In this case, the first snap-fit member 1111 and the first snap-fit matching member 21, as well as the second snap-fit member 22 and the second snap-fit matching member 1112, all form snap-fit engagement, thereby completing the installation of the first display module 5.

During disassembly: the first rotating shaft connector 2 is pulled out through an external force, causing both the marbles on the first slot 111 and on the first rotating shaft connector 2 to be compressed inward under pressure and detach from the first limiting groove 311. Once the first rotating shaft connector 2 is completely disengaged from the first slot 111, the first display module 5 and the stand body 1 are disassembled.

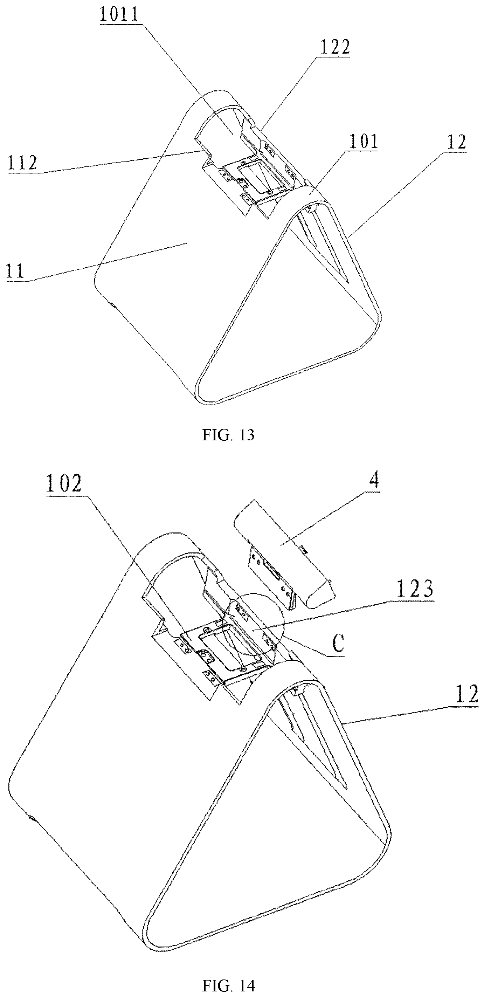

In one embodiment of the invention, as shown in FIG. 13, a first notch 112 is formed in one end of the first mounting surface 11 close to the top 101, a second notch 122 is formed in one end of the second mounting surface 12 close to the top 101, and the first notch 112 communicates with the second notch 122, such that the fastening portion 1011 is formed at the top 101. The internal module 103 on the supporting platform 102 is assembled through the fastening portion 1011.

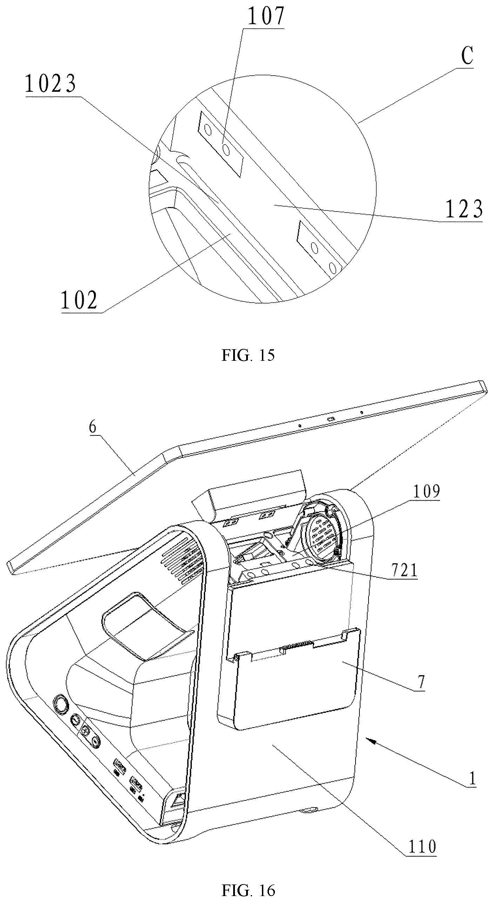

In the invention, as shown in FIGs. 14 and 15, a second slot 123 is formed in the second mounting surface 12, and the second slot 123 is configured for arranging the detachable second display module 6. The dual-screen stand further includes a second rotating shaft connector 4, one end of the second rotating shaft connector 4 is inserted into the second slot 123, and the other end of the second rotating shaft connector 4 is configured to be connected to the second display module 6. In one optional implementation, the insertion directions of the first slot 111 and the second slot 123 are different. The insertion direction of the first slot 111 is along a horizontal direction, and the insertion direction of the second slot 123 is along a vertical direction. Meanwhile, a third slot 1023 is formed in the supporting platform 102, and the third slot 1023 communicates with the second slot 123. When the second rotating shaft connector 4 is inserted into the second slot 123, the second rotating shaft connector 4 is limited by the second slot 123 and cannot move along the horizontal direction. The second rotating shaft connector 4 is synchronously inserted into the third slot 1023, providing an upward supporting force for the second rotating shaft connector 4 through the supporting platform 102, thereby supporting and fixing the second display module 6. A threaded hole 107 is formed in the second slot 123, and the second display module 6 is arranged on the second mounting surface 12 by fitting with the threaded hole 107 through a screw.

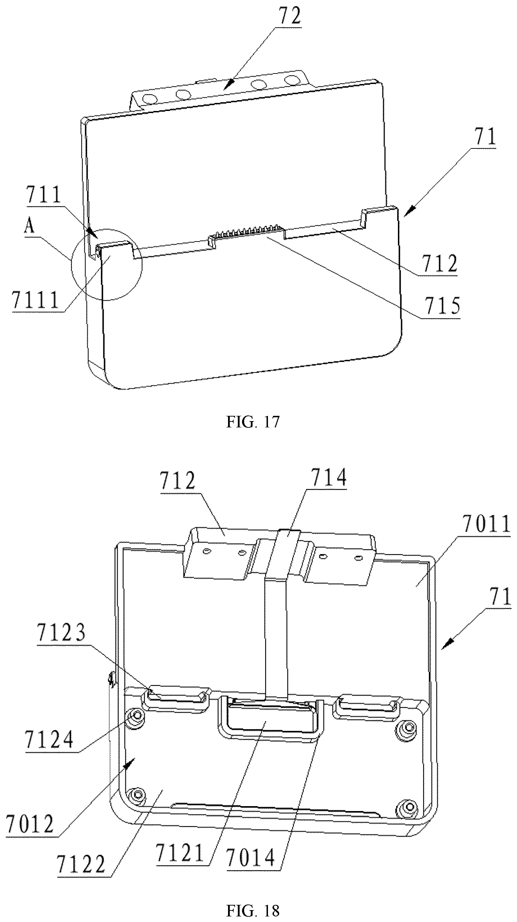

In one embodiment of the invention, as shown in FIGs. 16 and 17, the dual-screen stand further includes a hanger 7, and the hanger 7 includes a main body 71 and a hanging member 72. The hanging member 72 is arranged at a top end of the main body 71. In one optional implementation, an included angle is formed between the hanging member 72 and the main body 71, and the angle of the included angle matches the angle of the outer hanging surface 110. In the invention, the stand body 1 is of a triangular prism-like structure, an obtuse hanging angle is formed between the hanging platform 109 on the stand body 1 and the outer hanging surface 110, and a corresponding hanging angle is formed between the hanging member 72 and the main body 71. In one optional implementation, the hanging platform 109 is the above supporting platform 102, and the outer hanging surface 110 is the above first mounting surface 11.

As shown in FIG. 18, the side surface of the main body member 71 is of a "b"-like structure, and includes a vertical portion 7011 and a cavity portion 7012. The hanging member 72 is arranged at one end of the vertical portion 7011 away from the cavity portion 7012, an opening is formed in the surface of the cavity portion 7012, and a first data interface 713 is arranged in the opening. Meanwhile, a first positioning component 711 is further arranged on the surface of the side of the cavity portion 7012 where the first data interface 713 is arranged.

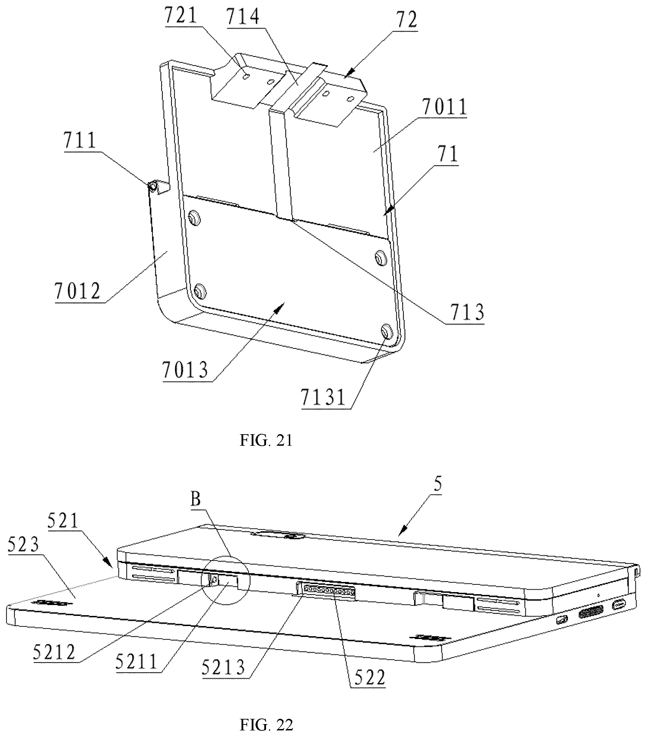

As shown in FIG. 18, an isolation edge 7014 is arranged in the cavity portion 7012; the isolation edge 7014 is arranged around an area where the first data interface 713 is located, forming an interface cavity 7121 and a circuit cavity 7122, and the circuit cavity 7122 is configured to place a circuit structure. Meanwhile, a sub-cavity 7123 is arranged in the area of the cavity portion 7012 corresponding to the first positioning component 711, a second positioning component 712 is arranged in the sub-cavity 7123 and is a magnet, and the magnet is used to attract and connect with the first display module 5. In other words, a magnet or a metal structure is also arranged in the corresponding area of the first display module 5, enabling the magnet to attract the first display module 5. In one optional implementation, a rear cover 7013 detachable from the cavity portion 7012 is further included; a positioning hole 7124 is formed in the cavity portion 7012, and a second fixing hole 7131 corresponding to the positioning hole 7124 is formed in the rear cover 7013, at least two positioning holes 7124 are formed in the cavity portion 7012, the positioning holes 7124 are formed along an inner edge of the cavity portion 7012, and second fixing holes 7131 in one-to-one correspondence with the positioning holes 7124 are formed in the rear cover 7013. As shown in FIG. 21, the cavity portion 7012 is rectangular, and four positioning holes 7124 are formed in the cavity portion 7012 and respectively formed in vertex positions inside the cavity portion 7012. Similarly, the rear cover 7013 is rectangular, and the fixing holes 7131 are respectively formed in vertex position of the rear cover 7013. The rear cover 7013 is fixed on the cavity portion 7012 through connecting elements such as screws or bolts.

As shown in FIG. 17, a first positioning component 711 and a second positioning component 712 are arranged on a connection end surface of the main body 71, the first positioning component 711 is used for detachable connection with the first display module 5, and the second positioning component 712 is used for cooperative connection with the first display module 5. In one optional implementation, the first positioning component 711 is used for detachable connection with the first positioning portion of the first display module 5; and the second positioning component 712 is used for cooperative connection with the second positioning portion of the first display module 5.

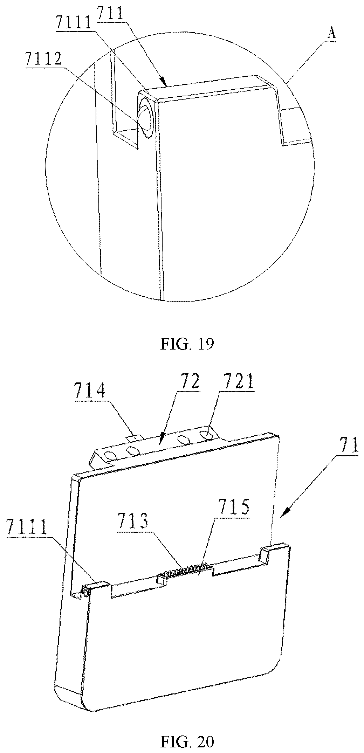

As shown in FIG. 19, an interface boss 715 is further arranged on the connection end surface of the main body 71. The first positioning component 711 includes a connecting boss 7111 or a connecting groove 5211, which is used for detachable connection with the connecting groove 5211 or the connecting boss 7111 on the first display module 5. The connection relationship is described by taking the first positioning component 711 as the connecting boss 7111, that is, the first positioning component 711 includes the connecting boss 7111, and the connecting boss 7111 is used for detachable connection with the connecting groove 5211 in the first display module 5. At least one connecting boss 7111 is respectively arranged on both sides of the interface boss 715. In addition, a connecting platform area is formed between the interface boss 715 and the connecting boss 7111, and the second positioning component 712 is arranged in the connecting platform area. Two connecting bosses 7111 are arranged in total in FIGs. 17 and 19, where a connecting platform area is formed between the connecting boss 7111 at the left side and the interface boss 715, and a connecting platform area is also formed between the connecting boss 7111 at the right side and the interface boss 715. Meanwhile, the second positioning components 712 are arranged in both two connecting platform areas. The second positioning component 712 uses a magnet, and the magnet can be arranged on the surface of the connecting platform area or inside the connecting platform area, effectively attracting and locating the first display module, such as a tablet device, through the magnet. When using a structure such as a Velcro, the second positioning component 712 needs to be arranged on the surface of the connecting platform area.

As shown in FIG. 19, a retractable limiting block 7112 is arranged on a side end surface of the connecting boss 7111. In this embodiment, a marble is used as the limiting block 7112, and this allows the marble to compress when pressed and to pop out for limiting when not pressed. In one optional implementation, the number of limiting blocks 7112 is determined according to the sizes of the limiting block 7112 and the connecting boss 7111. Moreover, the limiting blocks 7112 are respectively arranged on the end surfaces of both sides of the connecting boss 7111. For example, limiting blocks 7112 are arranged on both the left and right end surfaces of one connecting boss 7111.

In one embodiment of the invention, as shown in FIG. 20, a first data interface 713 is arranged on the surface of the main body member 71, and configured to be connected to the first display module 5. The first data interface 713 is arranged on the interface boss 715, and the height of the first data interface 713 is the same as that of the connecting boss 7111.

As shown in FIG. 21, a data cable 714 is arranged in the main body 71 and runs along the inner walls of the main body 71 and the hanging member 72. One end of the data cable 714 is connected to the first data interface 713, and the other end is electrically connected to the internal module 103 of the stand body 1. For example, if the first display module 5 is a tablet device and the internal module 103 of the stand body 1 is a control module of a cash register, one end of the data cable 714 is connected to the tablet device through the first data interface 713, and the other end is connected to the control module of the cash register, allowing the tablet device to function as a secondary screen of the cash register when connected to the hanger. In one optional implementation, a connecting hole 721 is formed in the hanging member 72 and configured to be connected to the supporting platform 102 of the stand body 1. As shown in FIGs. 16 and 21, four connecting holes 721 are formed in the hanging member 72. For example, the connecting holes 721 are threaded holes, and hole positions corresponding to the connecting holes 721 are arranged on the supporting platform 102 of the stand body 1. The hanging member 72 is then locked onto the supporting platform 102 through connecting elements such as screws. Meanwhile, the four connecting holes 721 are arranged in pairs on both sides of the data cable 714, the thickness of the middle part of the inner side of the hanging member 72 is smaller than that of the two sides, thereby providing a wiring space for the data cable 714 and preventing inability of the data cable 714 to effectively transmit data due to pressure after connection.

The assembly and disassembly process of the above hanger 7 and the tablet device is as follows.

After the hanging member 72 is positioned at a suitable angle on the outer hanging surface 110 of the stand body 1, the entire hanger can be connected to the stand body 1 by screws or other structural elements through the connecting holes 721 in the hanging member 72, and the data cable 714 is connected to the control module on the stand body 1. After the hanger 7 and the stand body 1 are assembled, the connection position between the hanging member 72 and the stand body 1 can be covered by the cover 33. Subsequently, when needed to be installed, the tablet device can be inserted into the first positioning component 711 and the second positioning component 712 of the main body 71. At the same time, the magnet in the hanger 7 plays a role in attracting and locating the tablet device, thereby completing the assembly of the tablet device. When needed to be used separately, the tablet device can be pulled out of the first positioning component 711 and the second positioning component 712 of the main body 71 by applying an external force. When the hanger 7 needs to be disassembled, the cover 33 is first removed to expose the connection position between the hanger 7 and the stand body 1, and the structural elements such as screws are the removed to separate the hanger 7 from the stand body 1 and disconnect the data cable 714 from the control module on the stand body 1, thereby completing the disassembly.

In one embodiment of the invention, as shown in FIGs. 2 and 16, an electronic device includes the dual-screen stand of the above embodiment. For example, the electronic device is a financial terminal such as a cash register, where the dual-screen stand is used to install the first display module 5 facing a user and the second display module 6 facing the staff respectively, or install the first display module 5 facing the staff and the second display module 6 facing the user respectively.

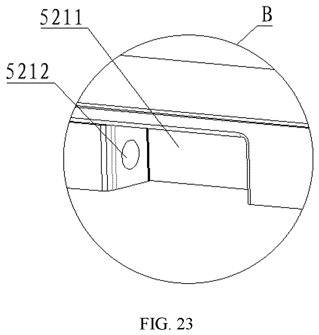

In one embodiment of the invention, as shown in FIGs. 22 and 23, the first display module 5 in the electronic device includes a connecting body 521, a second data interface 522, and a screen body 523. One side of the connecting body 521 is connected to the screen body 523, and the first display module 5 as a whole forms a stepped shape complementary to the hanger 7. A first positioning portion and a second positioning portion are arranged on a connection end surface of the connecting body 521. The first positioning portion is used for detachable connection with the first positioning component 711 of the hanger 7. The second positioning portion is used for cooperative connection with the second positioning component 712 of the hanger 7. The second data interface 522 is configured to be connected to the first data interface 713 on the hanger 7. Since the first positioning component 711 is a connecting boss 7111, correspondingly, the first positioning portion is a connecting groove 5211, meaning that the connecting groove 5211 in detachable connection with the connecting boss 7111 is formed in the connection end surface of the connecting body 521. A third limiting groove 5212 in detachable connection with the limiting block 7112 is formed in an inner side wall of the connecting groove 5211; an interface groove 5213 connected with the interface boss 715 is further formed in the connection end surface of the connecting body 521, and the second data interface 522 is arranged in the interface groove 5213. Meanwhile, magnets that attract with the magnets on the hanger 7 are arranged in the platform areas on both sides of the interface groove 5213. When the second positioning component 712 is a Velcro, the second positioning portion is of a corresponding Velcro structure. The first display module 5 is also provided with structures such as a power interface, a data interface, and a camera, which are used to enable functions such as charging, data transmission, and shooting for the first display module 5.

The above descriptions are merely embodiments of the invention, and do not limit the patent scope of the invention. Any equivalent modifications made using the contents of the specification and accompanying drawings of the invention, or direct or indirect applications in related technical fields, are similarly included within the patent protection scope of the invention.

## Claims

1. A dual-screen stand, comprising a stand body (1), wherein the stand body (1) is of a triangular prism-like structure;
one of edges of the stand body (1) serves as a top (101);
the stand body (1) comprises a first mounting surface (11) and a second mounting surface (12) which are connected to the top (101);
the first mounting surface (11) is configured for arranging a detachable first display module (5); and
the second mounting surface (12) is configured for arranging a detachable second display module (6).

2. The dual-screen stand according to claim 1, wherein a supporting platform (102) is arranged on the edge at the top (101), and the supporting platform (102) is configured to place an internal module (103).

3. The dual-screen stand according to claim 1, wherein a first slot (111) is formed in the first mounting surface (11); and
the first slot (111) is configured for arranging the detachable first display module (5).

4. The dual-screen stand according to claim 3, further comprising a first rotating shaft connector (2);
one end of the first rotating shaft connector (2) is inserted into the first slot (111); and
the other end of the first rotating shaft connector (2) is configured to be connected to the first display module (5).

5. The dual-screen stand according to claim 3, wherein a shielding component (3) is arranged at an entrance of the first slot (111); and
the shielding component (3) comprises a baffle (31), and the baffle (31) is movably arranged at the entrance of the first slot (111).

6. The dual-screen stand according to claim 5, wherein the shielding component (3) further comprises a cover (33);
a fastening portion (1011) is arranged at the top (101);
the cover (33) is arranged on the fastening portion (1011); and
the baffle (31) is arranged on the cover (33) through a rotating shaft (32).

7. The dual-screen stand according to claim 6, wherein a torsion spring (34) is arranged on one side of the cover (33);
the torsion spring (34) is sleeved on the rotating shaft (32);
one end of the torsion spring (34) abuts against the cover (33),
the baffle (31) is provided with a first limiting groove (311); and
an abutting end (341) of the torsion spring (34) is arranged in the first limiting groove (311).

8. The dual-screen stand according to claim 6, wherein an insertion block (331) is arranged at a first end of the cover (33);
an insertion slot connected with the insertion block (331) is formed in the stand body (1); and
a first fixing hole (332) is formed in one side of the cover (33) close to the stand body (1), and the first fixing hole (332) is configured to be connected to the stand body (1).

9. The dual-screen stand according to claim 4, wherein first snap-fit members (1111) are arranged on inner walls of both sides of the first slot (111);
first snap-fit matching members (21) are arranged on both sides of the first rotating shaft connector (2) along an insertion direction;
the first snap-fit members (1111) are snap-fitted with the first snap-fit matching members (21);
second snap-fit matching members (1112) are arranged on the inner walls of both sides of the first slot (111);
second snap-fit members (22) are arranged on both sides of the first rotating shaft connector (2) along the insertion direction; and
the second snap-fit members (22) are snap-fitted with the second snap-fit matching members (1112).

10. The dual-screen stand according to claim 4, wherein sliding blocks (204) are arranged on both sides of the first rotating shaft connector (2) along the insertion direction; and
sliding channels (1113) adapted to the sliding blocks (204) are arranged on the inner walls of both sides of the first slot (111).

11. The dual-screen stand according to claim 4, wherein the end of the first rotating shaft connector (2) inserted into the first slot (111) is stepped;
the first rotating shaft connector (2) comprises a first-level connecting block (201), a second-level connecting block (202) and a third-level connecting block (203);
the second-level connecting block (202) has a greater length than the first-level connecting block (201);
the third-level connecting block (203) has a greater length and width than the first-level connecting block (201); and
the first slot (111) is stepped and adapted to the second-level connecting block and the third-level connecting block (203).

12. The dual-screen stand according to claim 11, wherein a wiring hole (2011) communicating along the insertion direction is formed in the first-level connecting block (201).

13. The dual-screen stand according to claim 1, wherein the stand body (1) further comprises a third mounting surface (13) parallel to the top (101);
a circuit mainboard (104) is arranged on the third mounting surface (13);
a wiring slot (121) is formed in one side of the second mounting surface (12) close to the first mounting surface (11); and
a connecting wire (105) for connecting the circuit mainboard (104) is arranged in the wiring slot (121).

14. The dual-screen stand according to claim 1, further comprising a hanger (7); wherein the hanger (7) comprises a main body (71) and a hanging member (72);
the hanging member (72) is arranged at the top of the main body (71); and
a hanging platform (109) on the stand body (1) and an outer hanging surface (110) form an obtuse hanging angle, and a corresponding hanging angle is formed between the hanging member (72) and the main body (71).

15. An electronic device, comprising the dual-screen stand as claimed in any one of claims 1-14.
